# EUROPEAN PATENT SPECIFICATION

(11) **EP 4 292 118 B1**
(45) Date of publication and mention of the grant of the patent: **17.12.2025**
(21) Application number: 22753107.6
(22) Date of filing: 14.01.2022
(51) Int. Cl.: H01J 37/32

(54) **C-SHROUD MODIFICATION FOR PLASMA UNIFORMITY WITHOUT IMPACTING MECHANICAL STRENGTH OR LIFETIME OF THE C-SHROUD**
C-MANTEL-MODIFIKATION FÜR PLASMAGLEICHFÖRMIGKEIT OHNE AUSWIRKUNG AUF DIE MECHANISCHE FESTIGKEIT ODER LEBENSDAUER DES C-MANTEL-KÖRPERS
MODIFICATION D'ÉPAULEMENT EN C POUR L'UNIFORMITÉ DU PLASMA SANS IMPACT SUR LA RÉSISTANCE MÉCANIQUE OU LA DURÉE DE VIE DE L'ÉPAULEMENT EN C

(30) Priority: 12.02.2021 US 202163149186 P
(43) Date of publication of application: 20.12.2023
(73) Proprietor: Lam Research Corporation, Fremont, CA 94538 (US)
(72) Inventor: MANKIDY, Pratik, Fremont, CA 94538 (US); KIM, Jaewon, Fremont, CA 94538 (US); SINGH, Harmeet, Fremont, CA 94538 (US); LI, Ming, Fremont, CA 94538 (US)
(74) Representative: Mewburn Ellis LLP
(86) International application number: PCT/US2022/012618
(87) International publication number: WO 2022/173557

(56) References cited:
- CN-A- 111 383 884
- US-A1- 2007 000 614
- US-A1- 2007 169 891
- US-A1- 2012 000 608
- US-A1- 2016 289 827
- US-A1- 2017 330 735
- US-A1- 2017 338 085
- US-A1- 2019 244 793
- US-A1- 2020 051 792
- US-A1- 2020 075 295
- US-A1- 2020 303 171

## Description

### TECHNICAL FIELD

The invention relates to a confinement ring used in a semiconductor process module.

### BACKGROUND

In semiconductor processing, a substrate undergoes various operations to form features that define integrated circuits. For example, for a deposition operation, the substrate is received into a processing chamber and, depending on type of feature to be formed, specific types of reactive gases are supplied to the chamber and a radio frequency power is applied to generate plasma. The substrate is received on a substrate support defined on a lower electrode, such as an electro static chuck. An upper electrode, such as a showerhead, is used to provide the specific types of reactive gases into the process chamber. A radio frequency power is applied to the reactive gases through a corresponding match network to generate the plasma used to selectively deposit ions over a surface of the substrate to form microscopic features. The reactive gases generate by-products, such as particulates and gases, etc., which need to be promptly removed from the plasma chamber in order to maintain the integrity of the microscopic features formed on the surface of the substrate.

To confine the generated plasma within a process region, a set of confinement rings are defined to surround the process region. Further, to improve the yield and to ensure the bulk of the plasma is over the substrate received for processing, the confinement rings surrounding the plasma region may be designed to extend the process region so as to cover not only the region above the substrate but also the region over an edge ring disposed to surround the substrate, when received for processing, and an outer confinement ring disposed adjacent to the edge ring. The set of confinement rings not only act to confine the plasma within the process region but also act to protect the inside structure of the processing chamber, including chamber walls. Documents US 2017/330735 Al, US 2020/075295 Al and US 2019/244793 Al disclose such confinement rings.

The integrity of the features formed on the surface of the substrate relies on uniform plasma density in the process region. Plasma uniformity can be modulated by adjusting the shape of a confinement ring (e.g., C-shroud) to increase the volume of the process region, such as disclosed in document US 2019/244793 Al, which relates to a plasma processing chamber wherein the lower surface of the upper RF-powered electrode is either stepped or tapered so as to modulate the plasma distribution in the confined plasma region. However, any changes to the shape or design of the confinement ring to increase the size of the volume in the confinement ring, for example, may require significant changes to the hardware used within the processing chamber, such as processing chamber spacer plate, mating hardware, etc.). Alternately, changes to the design of the confinement ring may result in compromising the mechanical strength, or reducing the lifetime of the confinement ring.

It is in this context that embodiments of the invention arise.

### SUMMARY

Various implementations of the invention define a design of a confinement ring used in a plasma processing chamber for confining plasma within a plasma region. The confinement ring is defined to include a upper horizontal section that extends between a outer radius and an upper inner radius, a lower horizontal section that extends between the outer radius and a lower inner radius, and a vertical section extending between a bottom surface of the upper horizontal section and a top surface of the lower horizontal section defined at the outer radius. The top surface of the lower horizontal section of the confinement ring is defined by a slope that is defined by an angle provided along the top surface down toward the lower inner radius. The slope results in a difference in the thickness of the lower horizontal section, wherein the thickness of the lower horizontal section near an inside radius of the confinement ring is greater than the thickness of the lower horizontal section at the lower inner radius. In some implementations, a bottom surface of the lower horizontal section is defined to be flat. Alternately, in addition to defining the slope at the top surface, a second slope is defined along a bottom surface of the lower horizontal section. The second slope is formed by a second angle provided along the bottom surface down toward the lower inner radius. The second slope at the bottom surface may be defined by adding additional material used for the confinement ring. The formation of the second slope along the bottom surface of the lower horizontal section, in some implementations, results in a thickness of the lower horizontal section near the inside radius to be equal to the thickness of the lower horizontal section at the lower inner radius. In alternate implementations, the formation of the second slope along the bottom surface of the lower horizontal section may result in the thickness of the lower horizontal section near the inside radius to be different from the thickness of the lower horizontal section near the lower inner radius. Modifying the shape of the confinement ring by including sloped geometry for the lower horizontal section assists in modulating the plasma uniformity within the plasma region without requiring re-designing of other hardware components of the plasma processing chamber. Further, the modifications done to the lower horizontal section, (e.g., defining sloped surface along both the top and bottom surface of the lower horizontal section) avoids adversely affecting the mechanical strength or the lifetime of the consumable confinement ring.

The lower horizontal section includes a plurality of slots defined along the length of the lower horizontal section. Each slot is defined to extend radially from an inner diameter to an outer diameter along the lower horizontal section and vertically between the top surface and the bottom surface of the lower horizontal section. The plurality of slots is used to remove the by-products and neutral gas species generated within the plasma region while ensuring optimal confinement of the plasma in the plasma region. In some implementations, each of the slots may be defined to include parallel slot geometry, in that an inner slot radius defined at the inner diameter is equal to an outer slot radius defined at the outer diameter. In alternate implementations, in addition to including sloped geometry for the lower horizontal section, the plurality of slots is defined using tapered slot geometry. The tapered slot geometry is beneficial as the slots experience differential wear along the length of the slot due to constant exposure to the plasma. The tapered slot geometry assists in optimally managing the limited space between the slots while improving the lifetime of use of the confinement ring.

For instance, the wear of the slot is greater at the inner diameter than at the outer diameter. This uneven wear may be attributed to the variance in the volume of plasma near the inner diameter of the slot as opposed to the outer diameter. When the wear reaches critical dimension, the confinement ring needs to be replaced to ensure plasma unconfinement does not occur. The tapered geometry of the slots assists in addressing the uneven wear while extending the lifetime of the confinement ring. The tapered slot geometry makes efficient use of the area around the slot by defining a narrow end at the inner diameter and a broader end at the outer diameter. The tapered geometry allows the narrow end of the slot to approach the critical dimension at about the same time as the broader end of the slot, resulting in the entire slot length reaching the critical confinement dimension at end of life. The tapered slot geometry makes efficient use of the area around the slot - especially at the outer diameter, thereby extending the usage life of the confinement ring while maintaining optimal plasma confinement within the plasma region. Consequently, the cost associated with the consumable confinement ring is lowered as the number of process cycles the confinement ring can be used in the plasma processing chamber is extended. Thus, with the modifications to the confinement ring structure (i.e., including the tapered slot profile and the sloped lower horizontal section) an original lifetime expectancy of the confinement ring is maintained (i.e., lifetime of the confinement ring is not compromised) without requiring re-design of other hardware components of the plasma processing chamber.

In one implementation, a confinement ring for use in a plasma processing chamber is disclosed. The confinement ring includes an upper horizontal section, a lower horizontal section and a vertical section. The upper horizontal section extends between an upper inner radius and an outer radius of the confinement ring. The lower horizontal section extends between a lower inner radius and the outer radius of the confinement ring. A top surface of the lower horizontal section provides for an angle down toward the lower inner radius, wherein the angle defines a slope along the top surface. The lower horizontal section includes an extension section that extends downward along the lower inner radius. The vertical section is disposed between the outer radius and an inside radius of the confinement ring. The vertical section connects the upper horizontal section to the lower horizontal section of the confinement ring.

In one implementation, a bottom surface of the lower horizontal section is flat, such that a first thickness of the lower horizontal section near the inside radius is greater than a second thickness of the lower horizontal section at the lower inner radius.

In one implementation, the first thickness is greater by about 10% to about 40% of the second thickness.

In one implementation, the angle defines a slope along the top surface of the lower horizontal section. The slope is defined to be between about 0.20° and about 1° measured from a horizontal x-axis.

In one implementation, a bottom surface of the lower horizontal section provides for a second angle down toward the lower inner radius. The second angle defines a second slope. The second angle of the second slope defined on the bottom surface is equal to the angle of the slope defined on the top surface of the lower horizontal section, such that a first thickness of the lower horizontal section near the inside radius is equal to a second thickness of the lower horizontal section defined at the lower inner radius.

In one implementation, a first height defined between a bottom surface of the upper horizontal section and the top surface of the lower horizontal section near the inside radius is less than a second height defined between the bottom surface of the upper horizontal section and the top surface of the lower horizontal section at the lower inner radius of the confinement ring.

In one implementation, the lower horizontal section, the upper horizontal section and the vertical section are integrally connected to define a C-shaped structure configured to confine plasma generated in the plasma processing chamber.

In one implementation, the lower horizontal section includes a plurality of slots. Each slot of the plurality of slots extends radially from an inner diameter to an outer diameter along the lower horizontal section. An inner slot radius of each slot at the inner diameter is equal to an outer slot radius at the outer diameter.

In one implementation, the inner diameter of the slot is greater than an inner ring diameter defined by the lower inner radius, and the outer diameter of the slot is less than an outer ring diameter defined by the outer radius of the confinement ring.

In one implementation, the lower horizontal section includes a plurality of slots. Each slot of the plurality of slots extends radially from an inner diameter to an outer diameter along the lower horizontal section. An inner slot radius of each slot at the inner diameter is less than an outer slot radius at the outer diameter.

In one implementation, a difference in the inner slot radius and the outer slot radius of each slot defines a slot taper, such that each slot tapers down from the outer diameter to the inner diameter. The inner slot radius and the outer slot radius influencing the slot taper are sized to be an inverse of a wear rate at the corresponding inner diameter and the outer diameter of the slot. A ratio of the inner slot radius to the outer slot radius is between about 1:1.1 and about 1:1.5.

In one implementation, the upper inner radius is greater than the lower inner radius of the confinement ring.

In one implementation, the extension section defined in the lower horizontal section extends vertically downward at the lower inner radius.

In one implementation, the extension section defined in the lower horizontal section is defined by an angled top section and a vertical bottom section. The angled top section provides a third angle down at a downward incline point defined on the top surface of the lower horizontal section at the lower inner radius and the vertical bottom section is defined to extend downward from a bottom portion of the angled top section.

In one implementation, a top surface of the upper horizontal section includes a plurality of holes. Each hole of the plurality of holes is configured to receive a portion of a fastener means defined on a bottom surface of the upper electrode for coupling the confinement ring to the upper electrode of the plasma processing chamber.

In one implementation, the extension section of the lower horizontal section is configured to rest on a radio frequency gasket defined on a top surface of a lower electrode of a plasma processing chamber.

In another alternate implementation, a confinement ring for use in a plasma processing chamber is disclosed. The confinement ring includes an upper horizontal section, a lower horizontal section and a vertical section. The upper horizontal section extends between an upper inner radius and an outer radius of the confinement ring. The lower horizontal section extends between a lower inner radius and the outer radius of the confinement ring. A top surface of the lower horizontal section provides for a first angle down toward the lower inner radius to define a first slope along the top surface. A bottom surface of the lower horizontal section provides for a second angle down toward the lower inner radius to define a second slope along the bottom surface. The lower horizontal section includes an extension section that extends down along the lower inner radius. The vertical section is disposed between the outer radius and an inside radius of the confinement ring. The vertical section connects the upper horizontal section to the lower horizontal section of the confinement ring.

In one implementation, the first angle of the first slope is equal a second angle of the second slope.

In one implementation, a first thickness of the lower horizontal section near the inside radius is equal to a second thickness of the lower horizontal section at the lower inner radius. A first height defined between a bottom surface of the upper horizontal section and the top surface of the lower horizontal section near the inside radius is less than a second height defined between the bottom surface of the upper horizontal section and the top surface of the lower horizontal section at the lower inner radius.

In one implementation, the lower horizontal section includes a plurality of slots. Each slot of the plurality of slots extends radially from an inner diameter to an outer diameter along the lower horizontal section. An inner slot radius of each slot at the inner diameter is equal to an outer slot radius of each slot at the outer diameter. The inner diameter of each slot is greater than an inner ring diameter of the confinement ring defined by the lower inner radius, and the outer diameter of the slot is less than an outer ring diameter of the confinement ring defined by the outer radius.

In one implementation, the lower horizontal section includes a plurality of slots. Each slot of the plurality of slots extends radially from an inner diameter to an outer diameter along the lower horizontal section. An inner slot radius of each slot at the inner diameter is less than an outer slot radius at the outer diameter.

In yet another alternate implementation, a plasma processing chamber for confining plasma within is disclosed. The plasma processing chamber includes a lower electrode for supporting a substrate and an upper electrode disposed over the lower electrode. The plasma processing chamber includes a confinement ring disposed between the lower electrode and the upper electrode. The confinement ring includes an upper horizontal section, a lower horizontal section, and a vertical section. The upper horizontal section extends between an upper inner radius and an outer radius of the confinement ring. The lower horizontal section extends between a lower inner radius and the outer radius of the confinement ring. A top surface of the lower horizontal section provides an angle down toward the lower inner radius. The angle defines a slope along the top surface. The lower horizontal section has an extension section that extends down along the lower inner radius. The vertical section is disposed between the outer radius and an inside radius of the confinement ring. The vertical section connects the upper horizontal section and the lower horizontal section of the confinement ring.

In one implementation, a bottom surface of the lower horizontal section provides a second angle down toward the lower inner radius. The second angle defines a second slope along the bottom surface. The second angle of the second slope defined along the bottom surface is equal to an angle of the slope defined on the top surface of the lower horizontal section.

In one implementation, the lower horizontal section includes a plurality of slots. Each slot of the plurality of slots is designed to extend radially from an inner diameter to an outer diameter along the lower horizontal section. An inner slot radius of each slot at the inner diameter is less than an outer slot radius of each slot at the outer diameter.

In one implementation, the inner diameter of each slot is greater than an inner ring diameter defined by the lower inner radius of the confinement ring, and the outer diameter of the slot is less than an outer ring diameter defined by the outer radius of the confinement ring.

In one implementation, the upper inner radius is greater than the lower inner radius of the confinement ring.

In one implementation, the lower horizontal section, the vertical section and the upper horizontal section of the confinement ring defines a contiguous C-shaped structure for confining plasma to a plasma region defined in the plasma processing chamber. The confinement ring is made from one of silicon, or polysilicon, or silicon carbide, or boron carbide, or ceramic, or aluminum.

In one implementation, the extension section is integral with the lower horizontal section, the vertical section and the upper horizontal section of the confinement ring. The extension section is configured to extend vertically below a bottom surface of the lower horizontal section.

In one implementation, the upper electrode is electrically grounded and the lower electrode is connected to a radio frequency power source through a corresponding match network.

### DESCRIPTION OF DRAWINGS

FIG. 1 illustrates an expanded vertical cross-sectional view of a portion of a plasma processing chamber in which a confinement ring is used, the confinement ring having a tapered geometry defined along a top surface of a lower horizontal section, in accordance with one implementation.
Figure 2A illustrates an example confinement ring with tapered geometry defined along a top surface of a lower horizontal section, in accordance with one implementation.
FIG. 2B illustrates an alternate implementation of the confinement ring illustrated in FIG. 2A, with the tapered geometry defined on both a top surface and a bottom surface of the lower horizontal section of the confinement ring.
FIG. 2C illustrates an alternate implementation of the confinement ring illustrated in FIG. 2A, with a top section of the extension section having a straight profile.
FIG. 3 illustrates a representative graph of variation of plasma density as it corresponds to an oxide blanket etch rate across the radius of a substrate surface (when present), in accordance with one implementation.
FIG. 4A illustrates an expanded view of a section of the confinement ring having the tapered geometry along a top surface of a lower horizontal section and a plurality of slots with parallel slot profile defined along the lower horizontal section, in accordance with one implementation.
FIG. 4B illustrates an alternate implementation of the confinement ring illustrated in FIG. 4A, with the tapered geometry along the top and bottom surfaces of the lower horizontal section and the plurality of slots with tapered geometry defined along the lower horizontal section of the confinement ring.
FIG. 5A illustrates an expanded view of the tapered geometry of a slot defined along the lower horizontal section of the confinement ring, in accordance with one implementation.
FIG. 5B illustrates an expanded view of a starting profile of a slot with tapered geometry and a slot wear profile at end-of-life of the confinement ring, in accordance with one implementation.
FIG. 6 is a top perspective view of the confinement ring, in accordance with one implementation.

### DETAILED DESCRIPTION

In the various implementations described herein, a confinement ring for use in a plasma processing chamber is designed to improve the usage life of the confinement ring while ensuring optimal plasma confinement within a plasma region defined in the plasma processing chamber. The confinement ring used in the plasma processing chamber includes an upper horizontal section, a vertical section and a lower horizontal section. The upper horizontal section is defined to extend from an outer radius to an upper inner radius and a top surface and a bottom surface of the upper horizontal section is defined to be flat. The lower horizontal section is defined to extend from the outer radius to a lower inner radius. The vertical section is disposed between the outer radius and an inside radius of the confinement ring and connects the upper horizontal section to the lower horizontal section of the confinement ring. A top surface of the lower horizontal section includes a tapered geometry to define a slope that slopes down toward the lower inner radius. The slope defined at the top surface results in a variation in thickness of the lower horizontal section of the confinement ring near the inside radius and the lower inner radius. Additionally, the slope results in a variation in a height of the gap defined between a bottom surface of the upper horizontal section and the top surface of the lower horizontal section near the inside radius and at the lower inner radius. The variation in the height results in an increase in the volume of the plasma generated in the plasma region, particularly in the region covered by the confinement ring (e.g., over the edge exclusion region of the substrate, when present in the plasma processing chamber, and in the region over an edge ring surrounding the substrate).

Increasing the gap in the confinement ring positively affects the plasma uniformity. The plasma uniformity may be attributed to changes in the plasma diffusion due to the increased volume within the plasma region. Thus, plasma uniformity can be modulated by changing a shape of the confinement ring used to confine the plasma in the plasma region without requiring re-designing other hardware components of the plasma processing chamber. Existing methods for changing the conventional design of the confinement ring require significant changes to the hardware, or result in compromising mechanical strength and consequently the lifetime of the confinement ring.

Select changes are made to the confinement ring (e.g., including a slope along a lower horizontal section of the confinement ring) to increase the volume of the plasma. The changes made to the confinement ring do not require modification to any other hardware component (e.g., chamber spacer plate, mating hardware, etc.,) within the plasma processing chamber as the changes made to the confinement ring structure do not substantially deviate from the overall structure of confinement ring. Additional improvements may be made to a bottom surface of the lower horizontal section by including a slope, in some implementations, to improve the mechanical strength of the confinement ring and the overall lifetime of the confinement ring. The slope may be defined in the bottom surface by adding additional material of the confinement ring along the length of the bottom section so as to provide an angle down toward the lower inner radius. The additional material in the bottom surface is designed to increase the thickness of the lower horizontal section so as to provide overall thickness uniformity along the length of the lower horizontal section while continuing to maintain the slope at the lower horizontal section.

The lower horizontal section includes a plurality of slots for efficient removal of by-products from the plasma region while preserving plasma confinement within the plasma region. The slots are defined to extend lengthwise from an inner diameter to an outer diameter along the lower horizontal section and depth-wise between the top surface and the bottom surface of the lower horizontal section so as to provide the conduit for the by-products out of the plasma region. The slots, in some implementation, may be defined to include parallel slot geometry along the length, wherein the inner slot radius at the inner diameter is the same as the outer slot radius at the outer diameter. In alternate implementations, the slots may be defined to include tapered slot geometry, such that the slot is narrow at the inner diameter and is broad at the outer diameter. The broader side at the outer diameter has a broader outer slot radius and the narrow side at the inner diameter has a narrow inner slot radius. The inner slot radius at the inner diameter and the outer slot radius at the outer diameter of each slot are sized to be an inverse of the wear rate at the corresponding inner diameter and the outer diameter. By starting with a narrower slot at the inner diameter allows for more wear to occur at the inner diameter before critical dimension for plasma un-confinement is reached. At end of the usage life, the smaller inner slot radius at the inner diameter compensates for the high wear rate at the inner diameter while the broader outer slot radius compensates for the low wear rate at the outer diameter thereby resulting in a straight slot profile along the length of the slot. The difference in the inner slot radius and the outer slot radius results in each slot along the entire slot length to reach the confinement limit at the same time. The tapered slot may result in some open area along the narrow side. To compensate for the open area along the narrow side, the total number of slots may be increased. The increase in the total number of slots takes into consideration the amount of wear anticipated along the narrow side of the tapered slots.

The modified confinement ring structure with the sloped geometry along the length of the lower horizontal section and the tapered slot geometry of the plurality of slots defined along the length of the lower horizontal section results in, (a) overall improvement in the plasma uniformity, (b) efficient removal of the by-products, and (c) overall improvement in the lifetime of the confinement ring. The aforementioned benefits are realized without requiring re-design of other hardware components (e.g., chamber spacer plate, mating hardware, etc.,) within the plasma processing chamber. With the aforementioned overview of the invention, specific implementations will now be described with reference to the various figures.

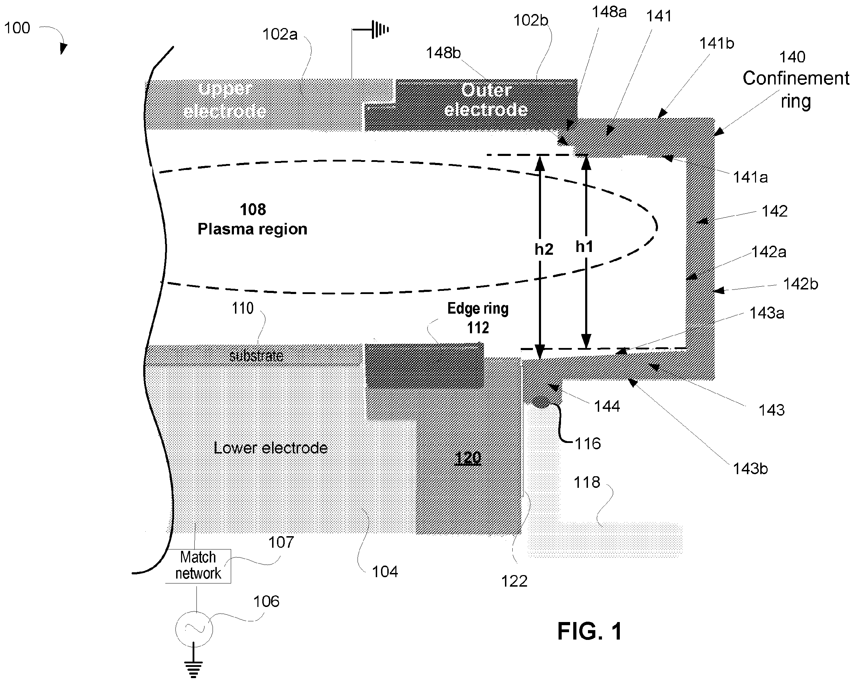

FIG. 1 illustrates a simplified block diagram of a portion of a plasma processing chamber 100 that uses a confinement ring for confining plasma, in one implementation. The plasma processing chamber 100, in one implementation, may be a capacitively-coupled plasma (CCP) processing chamber (or simply referred to henceforth as a "plasma processing chamber"), which includes a lower electrode 104 to provide radio frequency (RF) power to the plasma processing chamber 100, and an upper electrode 102 to provide process gases to generate plasma within the plasma processing chamber 100. The lower electrode 104 is connected to a RF power source 106 through a corresponding match network 107, wherein a first end of the RF power source 106 is connected to the match network 107 and a second end of the RF power source 106 is electrically grounded. The RF power source 106 may include one or more RF power generators (not shown).

In one implementation, a top surface of the lower electrode 104 defines a substrate support surface on which a substrate 110 is received for processing. An edge ring 112 is defined adjacent to the substrate support surface of the lower electrode 104 so as to surround the substrate 110, when the substrate 110 is received for processing. The top surface of the edge ring 112 is defined to be co-planar with a top surface of the substrate 110, when the substrate is supported on the substrate support surface of the lower electrode 104. The edge ring 112 is configured to extend the processing region for the plasma (represented by the plasma region 108) generated within the plasma processing chamber 100 to extend over an area that is beyond an edge of the substrate to an extended processing region covering an outer edge of the edge ring 112 and beyond. One or more dielectric rings 120 are disposed adjacent to the outer edge of the edge ring 112. RF power source 106 is connected to a bottom portion of the lower electrode via the match network 107 and provides RF power to the plasma processing chamber 100. A ground ring 122 is disposed adjacent to and below a portion of the one or more dielectric rings 120 and is configured to surround the lower electrode 104. A support structure 118 is disposed to surround a portion of the ground ring 122 of the lower electrode 104. A RF gasket 116 is disposed on a top surface of the support structure 118. In some implementation, the RF gasket 116 may be disposed within a channel defined on the top surface of the support structure 118. The support structure 118 may be made of a quartz element or any other insulation material that is suitable for use in the plasma processing chamber 100.

In one implementation, the upper electrode 102 may be a showerhead that includes one or more inlets (not shown) connected to one or more process gas sources (not shown) and a plurality of outlets distributed at a bottom surface of the upper electrode 102 facing the lower electrode 104. The plurality of outlets are configured to supply the process gases from the one or more process gas sources to a plasma processing region (or simply referred to as "plasma region") 108 defined between the upper electrode 102 and the lower electrode 104. The upper electrode 102 may be made up of a plurality of electrodes. Figure 1 illustrates one such implementation in which the upper electrode 102 includes an inner upper electrode 102a disposed in the center, and an outer electrode 102b that is disposed adjacent to and surround the inner upper electrode 102a. The upper electrode 102, in this implementation, is electrically grounded to provide the RF power supplied to the plasma processing chamber 100 a return path to ground. The outer electrode 102b includes a plurality of fastener means (not shown) that are disposed along a bottom surface. The fastener means are used to couple the upper electrode 102 to a confinement ring 140.

The confinement ring structure (or simply referred to henceforth as "confinement ring") 140 is disposed between the upper electrode 102 and the lower electrode 104. The confinement ring 140 defines a confined chamber volume in which the plasma generated in the chamber is sufficiently contained. The confinement chamber volume defines the plasma region 108. The confinement ring 140 is a C-shaped structure with an opening of the C-shape facing an inside of the plasma region 108 defined between the upper and the lower electrodes 102, 104, of the processing chamber 100. Based on the shape of the confinement ring 140 and the function to confine the plasma to an area, the confinement ring may also be referred to as a "C-shroud". The confinement ring 140 is used to confine the plasma within an extended plasma region 108 in the plasma processing chamber 100. The confinement ring 140 is configured to be coupled at the top to the outer electrode 102b that is part of the upper electrode 102. The confinement ring 140 is part of the upper electrode 102 and a bottom section of the confinement ring 140 is configured to rest on a top surface of a support structure 118 of the lower electrode 104. An RF gasket 116 is provided on the top surface of the support structure 118 to provide a tight coupling between the upper electrode 102 and the lower electrode 104, when the plasma processing chamber 100 is to be engaged for processing. The RF gasket 116 ensures that the coupling between the upper and the lower electrodes 102, 104 is air-tight. In one implementation, the support structure 118 is configured to surround a region of the lower electrode 104 that includes at least the substrate support surface, the edge ring 112, the one or more dielectric rings 120, and the ground ring 122.

It is to be noted that the plasma processing chamber of FIG. 1 is shown to include only specific parts, whereas in reality the plasma processing chamber includes a plurality of additional components that are needed for processing substrate. Further, the various components shown in FIG. 1 may not be to scale and/or may be exaggerated in order to identify the different features of the various components.

Broadly speaking, the confinement ring 140 includes an upper horizontal section 141, a vertical section 142, and a lower horizontal section 143. The upper horizontal section 141 extends a first length and is defined by a bottom surface 141a that faces the plasma region 108 and a top surface 141b that faces away from the plasma region 108. A plurality of holes are distributed across the top surface 141b to receive fastener means defined on the bottom surface of the outer electrode 102b when coupling the confinement ring 140 to the upper electrode 102. In one implementation, the bottom surface 141a and the top surface 141b of the upper horizontal section 141 are substantially flat (i.e., horizontal). In another implementation, a first step 148a is defined on the top surface 141b of the upper horizontal section 141 at the inside edge of the upper horizontal section 141. The first step may be used to receive the outer electrode 102b and may be used to offer reliable mating of the confinement ring 140 when coupling the confinement ring 140 to the outer electrode 102b. In this implementation, the bottom surface 141a of the upper horizontal section 141 is substantially flat. In yet another implementation, the first step 148a is defined on the top surface 141b of the upper horizontal section 141 and a second step 148b is defined on the bottom surface 141a of the upper horizontal section 141 at the inside edge of the upper horizontal section 141. In this implementation, the first step 148a and the second step 148b may both extend for a height. In another implementation, the first step 148a may extend for a first height and the second step 148b may extend for a second height. In another implementation, the bottom surface 141a of the upper horizontal section 141 provides for an angle up toward an upper inner radius 151 to define a slope along the upper horizontal section. The angle of the slope on the bottom surface of the upper horizontal section, in one example, may be defined to be greater than 0° and less than 1°, although other ranges for the slope may also be envisioned.

The vertical section 142 includes an inner surface 142a that is facing the plasma region 108 and an outer surface 142b that is facing away from the plasma region 108 and toward an inner side of a wall of the processing chamber 100. In one implementation, the inner surface 142a and the outer surface 142b of the vertical section 142 is vertical. FIG. 1 shows one such example of the inner surface 142a and the outer surface 142b of the vertical section 142 being vertical. In another implementation, the inner surface 142a of the vertical section 142 is bowed while the outer surface 142b of the vertical section 142 is vertical. In yet another implementation, both the inner surface 142a and the outer surface 142b of the vertical section 142 are both bowed.

The lower horizontal section 143 extends a second length and is defined by a top surface 143a that is facing the plasma region 108 and a bottom surface 143b that is facing away from the plasma region 108. The top surface 143a of the lower horizontal section 143 is sloped down from the vertical section toward an inside edge of the lower horizontal section 143. The slope in the lower horizontal section 143 causes a variation in height of a gap defined between the upper horizontal section 141 and the lower horizontal section 143. In some implementation, a first height 'h1' defined between the upper and lower horizontal sections 141, 143 near the vertical section 142 is less than a second height 'h2' defined between the upper and lower horizontal sections 141, 143 near the inside edge of the lower horizontal section 143. Additionally, the lower horizontal section 143 includes an extension section 144 that is disposed at the inside edge of the lower horizontal section 143 and extends down from the bottom surface 143b of the lower horizontal section 143. In one implementation illustrated in FIG. 1, the extension section 144 includes an inside surface that is straight.

In one implementation, the upper horizontal section 141, the vertical section 142 and the lower horizontal section 143 may be integrally connected to define a C-shaped structure. In another implementation, the upper horizontal section 141, the vertical section 142 and the lower horizontal section 143 may be three separate pieces with a bottom surface of the upper horizontal section 141 designed to rest on top of the vertical section 142 and be coupled to a top surface of the vertical section 142. A bottom surface of the vertical section 142 is designed to rest on top of the lower horizontal section 143 and be coupled to the top surface 143a of the lower horizontal section 143. The upper horizontal section 141, the vertical section 142 and the lower horizontal section together form a C-shaped structure for confining the plasma generated within the plasma processing chamber 100 to the plasma region 108.

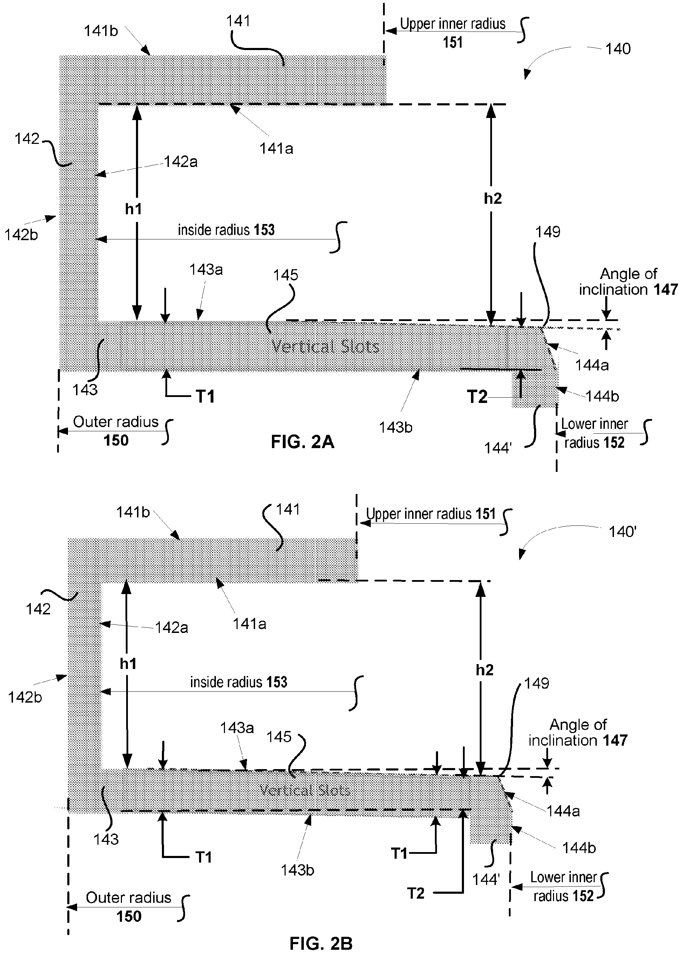

FIG. 2A illustrates an expanded cross-sectional view of the confinement ring 140 used in the plasma processing chamber 100, in one implementation. The illustration of FIG. 2A identifies the various reference points of the confinement ring 140. As noted, the confinement ring 140 is a C-shaped structure and includes an upper horizontal section 141, a vertical section 142, a lower horizontal section 143 and an extension section 144. The upper horizontal section 141 extends between an outer radius 150 and an upper inner radius 151 of the confinement ring 140 and includes a bottom surface 141a and a top surface 141b. The bottom surface 141a and the top surface 141b of the upper horizontal section 141 may or may not include a step at the upper inner radius 151. The bottom surface 141a faces the plasma region 108 and the top surface 141b faces away from the plasma region 108. The top surface 141b of the upper horizontal section 141 includes a plurality of fastener holes (or simply referred to as "holes" - not shown) distributed uniformly in a circular orientation and defined to align with corresponding fastener means disposed along a bottom surface of the outer electrode 102b. The fastener means of the outer electrode 102b and the fastener holes on the top surface 141b of the outer electrode 102b are defined to couple the confinement ring 140 to the upper electrode 102.

The vertical section 142 of the confinement ring is disposed between the outer radius 150 and an inside radius 153 of the confinement ring 140. The vertical section 142 includes an inner surface 142a facing the inside of the plasma region 108 and the outer surface 142b facing away from the plasma region 108. One or both of the inner surface 142a and outer surface 142b of the vertical section 142 may be vertical or bowed. The vertical section extends between the upper horizontal section 141 and the lower horizontal section 143 for a height to define a gap in which the plasma is confined. In some implementations, the vertical section 142 couples the upper horizontal section 141 to the lower horizontal section 143 to define the C-shaped structure.

The lower horizontal section 143 extends between the outer radius 150 and a lower inner radius 152 of the confinement ring 140. In one implementation, the lower inner radius 152 of the confinement ring 140 is smaller than the upper inner radius 151 of the confinement ring 140. The lower horizontal section includes a top surface 143a and a bottom surface 143b. The top surface 143a of the lower horizontal section 143 is defined to provide an angle down toward the lower inner radius 152, while the bottom surface 143b of the lower horizontal section 143 is defined to be flat. The angle defines a slope along the top surface 143a of the lower horizontal section 143. In one implementation, the slope begins near the inside radius 153 of the confinement ring and extends toward the lower inner radius 152. The top surface 143a with the slope and the bottom surface 143b with a flat profile results in a variation in the thickness along the length of the lower horizontal section 143. For instance, the slope along the top surface 143a results in the lower horizontal section 143 to have a first thickness 'T1' near the inside radius 153 of the confinement ring 140 and a second thickness 'T2' near the lower inner radius 152 of the confinement ring 140, wherein T1 > T2. In one implementation, the first thickness T1 is defined to be about 10% to about 40% greater than the second thickness T2. Further, the variation in the thickness causes a variation in the height of a gap defined between the bottom surface 141a of the upper horizontal section 141 and the top surface 143a of the lower horizontal section 143, wherein the gap defines the plasma region 108. For instance, the slope results in a first height 'h1' defined near the inside radius of the confinement ring 140 and a second height 'h2' near the lower inner radius 152, wherein the first height h1 is less than the second height h2.

In one implementation, an angle of inclination 147 defined by the slope in the lower horizontal section 143 to a horizontal x-axis may be defined to be between about 0.20° and about 1°. The aforementioned range for the angle of the slope is provided as a mere example and should not be considered restrictive. Consequently, in some implementations, the angle of the slope can be envisioned to be greater or lesser than the range, and such increase or decrease in the angle may be based on the inner dimensions of the plasma processing chamber 100, type of process that is being performed, type of process gases used to generate the plasma, type of by-products and neutral gas species that are generated and are to be removed, access openings of the plasma processing chamber, etc. In one implementation, the confinement ring is made of silicon. In other implementations, the confinement ring may be made of polysilicon, or silicon carbide, or boron carbide, or ceramic, or aluminum, or any other material that can withstand the processing conditions of the plasma region 108.

The lower horizontal section 143 includes an extension section 144' defined at the lower inner radius 152. In the implementation illustrated in FIG. 2A, the extension section 144' includes an angled top section 144a and a vertical bottom section 144b. This design of the extension section 144 is different from the design used in FIG. 1, in that the extension section 144 of FIG. 1 includes a straight inside surface of the extension section, whereas the extension section of FIG. 2A includes an inclined portion in the top portion of the extension section 144'. The angled top section 144a defined at a downward incline point 149 is inclined at an angle, wherein the downward incline point 149 is defined at an intersection of the top surface 143a and the inside surface of the lower inner radius 152. The inclination angle of the angled top section 144a may be between about 0° and about 10°. The aforementioned range is provided as an example and should not be considered restrictive or exhaustive. The vertical bottom section 144b is disposed below the angled top section 144a and extends vertically down for a height beyond the bottom surface 143b of the lower horizontal section 143. The extension section 144' provides continuity to the lower horizontal section 143. The vertical bottom section 144b is configured to rest on the RF gasket 116 disposed on the top surface of the support structure118 defined in the lower electrode 104.

FIG. 2B illustrates a variation in the design of the confinement ring 140 illustrated in FIG. 2A, in one implementation. The confinement ring 140' in FIG. 2B includes a second slope defined along a bottom surface 143b of the lower horizontal section 143 that is in addition to the slope defined on the top surface 143a of the lower horizontal section 143 of the confinement ring 140. The various components of the confinement ring 140 that are common to both FIGs. 2A and 2B are represented using same reference numerals and function in a similar manner. The bottom surface 143b of the lower horizontal section 143 is defined to provide a second angle down toward the lower inner radius 152 to define a second slope along the bottom surface 143b of the lower horizontal section 143. Similar to the implementation of the slope of FIG. 2A, the second slope is defined to begin near the inside radius 153 of the confinement ring and extend toward the lower inner radius 152. In one implementation, the second angle of the second slope defined along the bottom surface 143b of the lower horizontal section 143 is equal to the angle of the slope defined along the top surface 143a of the lower horizontal section 143. For instance, the second slope is defined to be between about 0.20° and about 1°. In this implementation, the thickness of the lower horizontal section 143 is uniform along the length of the lower horizontal section 143.

In another implementation, the second angle of the second slope defined along the bottom surface 143b may be different from the slope defined along the top surface 143a. For instance, the second angle of the second slope may be greater than the angle of the slope along the top surface 143a leading to a variation in the thickness along the length of the lower horizontal section 143. In this implementation, the thickness T1 near the inside radius 153 may be less than the thickness T2 near the lower inner radius 152. This implementation is a variation of the implementation illustrated in FIG. 2A, in that the thickness varies along the length of the lower horizontal section 143. For instance, the thickness T1 near the inside radius 153 is less than the thickness T2 near the lower inner radius 152, whereas in the implementation of FIG. 2A, thickness T1 near the inside radius 153 is greater than thickness T2 near the lower inner radius 152. This may be to accommodate additional wear anticipated at the lower inner radius 152 due to exposure to the plasma in the plasma region 108.

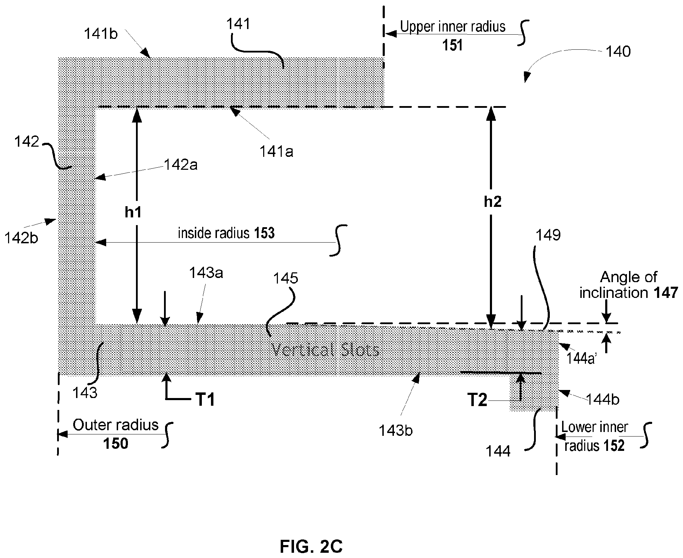

FIG. 2C illustrates an alternate implementation of the confinement ring 140 illustrated in FIG. 2A. In this implementation, the extension section 144 is defined by a top section 144a' and a vertical bottom section 144b. The top section 144a' is shown to include a straight profile along the inside surface disposed at the lower inner radius 152 instead of the angled top section illustrated in FIG. 2A. In the implementation illustrated in FIG. 2C, the top section 144a' extends down at the lower inner radius 152 up to the bottom surface 143b of the lower horizontal section 143 and the vertical bottom section 144b is an extension of the top section 144a', wherein the vertical bottom section 144b extends below the bottom surface 143b of the lower horizontal section 143 of the confinement ring 140.

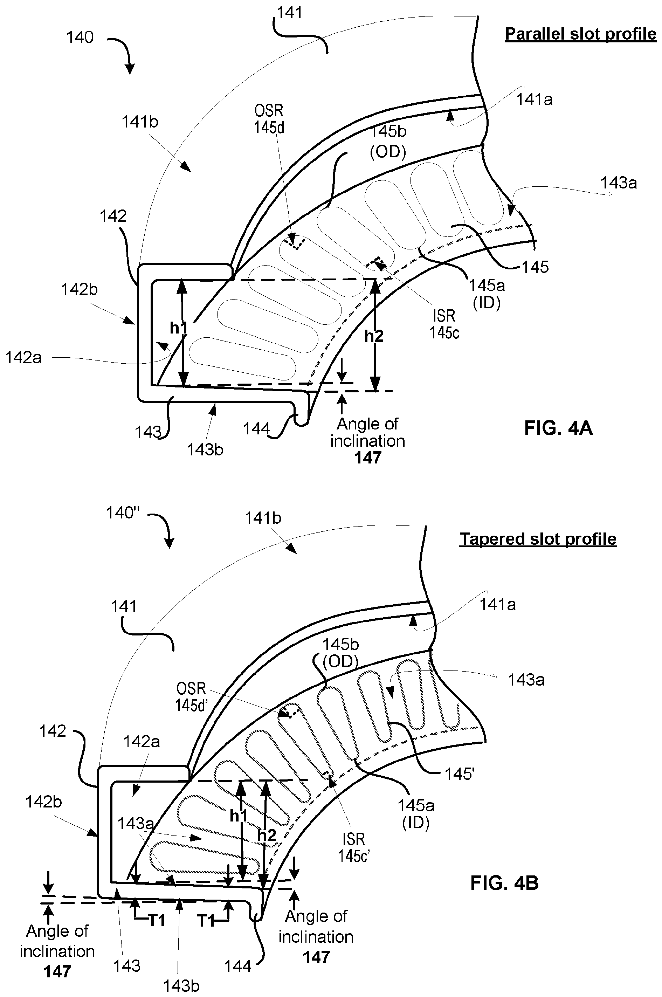

The implementations illustrated in FIGs. 2A - 2C show vertical cross-sectional views of the confinement ring 140 with slope defined along the top surface 143a and along both the top surface 143a and bottom surface 143b. The cross-sectional view of FIGs. 2A and 2B also show a slot 145 defined along the length of the lower horizontal section 143 of the confinement ring 140. The confinement ring 140 includes a plurality of slots distributed uniformly along the lower horizontal section 143 of the confinement ring 140, wherein each slot extends length-wise between an inner diameter and an outer diameter and depth-wise between the top surface 143a and the bottom surface 143b of the lower horizontal section. Details related to the geometry of the slots will be described with reference to FIGs. 4A and 4B. The plurality of slots 145 defined along the lower horizontal section 143 provide a conduit for the by-products to escape the plasma region while optimally confining the plasma within the plasma region.

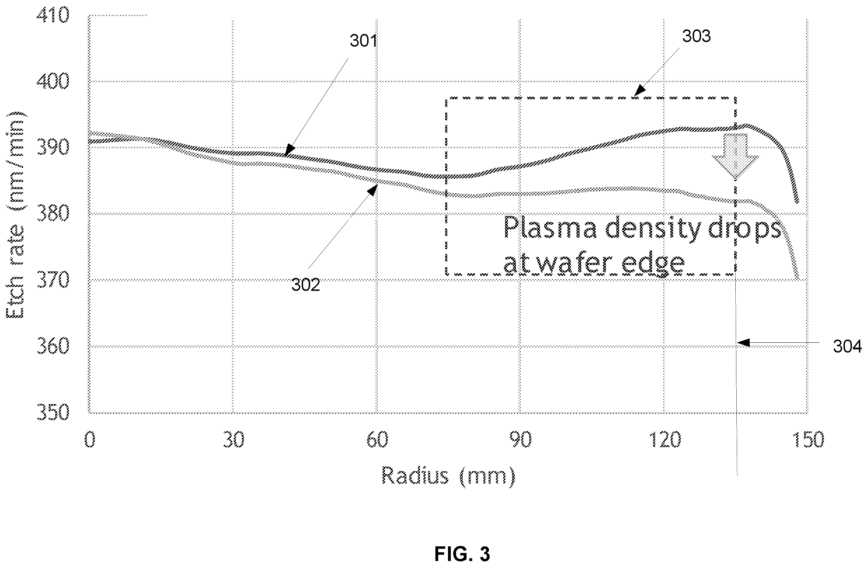

FIG. 3 illustrates a graph identifying variation in etch rate due to variation in plasma density across the radius of a substrate when a confinement ring with the sloped geometry defined in the lower horizontal section 143 is used, in one implementation. The graph shows an oxide blanket etch rate across the surface of the substrate processed using the confinement ring with sloped geometry as described in the various implementations. The blanket etch rate is indicative of a reasonable measure of the plasma density over the surface of the substrate. Graph line 301 shows the variation in the etch rate on the substrate surface when a confinement ring without the slope is used and graph line 302 shows the variation in the etch rate on the substrate surface when a confinement ring with the slope defined along the lower horizontal section 143 is used. The etch rate represented along graph line 301 shows a lot more variation along the length of the substrate up to an edge-exclusion region defined by line 304. The variation in the etch rate is more pronounced in graph line 301 for the radius between about 70 mm and about 135 mm for a 150 mm substrate, as can be seen in the box 303. For instance, the etch rate shows a gradual decrease along the substrate surface up to a midpoint of the radius (i.e., up to about 70 mm) after which the etch rate begins to increase significantly up till the edge exclusion region of the substrate. On the other hand, graph line 302 shows a more gradual decrease in the etch rate along the length of the substrate surface up till the edge exclusion region. The gradual decrease in the etch rate shown in graph line 302 is postulated to be due to changes in plasma diffusion in the increased plasma volume resulting from an increase in the gap defined between the upper horizontal section and the lower horizontal section of the confinement ring 140.

In one implementation, the amount of slope along the lower horizontal section may be defined to increase the first height 'h1' and the second height 'h2' (i.e., the gap defined between the upper horizontal section 141 and the lower horizontal section 143) by about + 2 mm to about +8mm. The impact of such increase on blanket etch rate, is shown by the graph line 302, especially in the region covered by box 303. As an example, a slope of between about 0.55° and about 0.60° defined along the top surface 143a of the lower horizontal section 143 would result in a difference in the second height 'h2' from about 0.60 mm to about 0.65 mm from the first height 'h1'. In one implementation, the upper inner radius 151 is defined to be between about 203 mm (about 8 inches) and about 218.5 mm (about 8.6 inches). In one implementation, the lower inner radius 152 is defined to be between about 177 mm (about 7 inches) and about 198.5 mm (about 7.8 inches). In one implementation, the inside radius 153 is defined to be between about 248 mm (about 9.8 inches) and about 262 mm (about 10.3 inches). In one implementation, the outer radius is defined to be between about 254 mm (about 10 inches) and about 267 mm (about 10.5 inches). In one implementation, the length of the slot 145 is defined to be between about 48 mm (about 1.9 inches) and about 61 mm (about 2.4 inches). In one implementation, the depth of the lower horizontal section 143a (i.e., thickness T1) is defined to be between about 6 mm (about 0.25 inch) and about 8.4 mm (about 0.33 inch). In one implementation, the slope defined on the lower horizontal section 143a may result in the first height h1 to be between about 29 mm (about 1.18 inches) and about 31 mm (about 1.22 inches) and the second height to be between about 31 mm (about 1.22 inches) and about 32 mm (about 1.24 inches). In one implementation, thickness T2 due to the slope on the lower horizontal section 143a may be defined to be between about 5.8 mm (about 0.23 inch) and about 7.2 mm (about 0.28 inch). The aforementioned range for the various components of the confinement ring has been provided as mere examples and should not be considered restrictive. Other ranges or adjustment to aforementioned ranges for the various components may be envisioned based on the inner dimensions of the plasma processing chamber 100, type of process that is being performed, type of process gases used to generate the plasma, type of by-products and neutral gas species that are generated and are to be removed, access openings of the plasma processing chamber, geometry of hardware components of the plasma processing chamber, etc.

FIGs. 4A and 4B illustrate variations of a confinement ring with a plurality of slots defined along a length of a lower horizontal section 143 of the confinement ring 140, in some example implementations. The plurality of slots 145 along the length of the lower horizontal section 143 is used to efficiently remove the by-products formed within the plasma region 108 during the processing of the substrate 110. In the example implementation illustrated in FIG. 4A, each slot 145 of the plurality of slots is shown to extend radially between an inner diameter (ID) 145a and an outer diameter (OD) 145b of the lower horizontal section 143. The ID 145a of the slot 145 is greater than an inner ring diameter (IRD) of the lower horizontal section 143, wherein the IRD is defined by the lower inner radius 152 of the lower horizontal section 143. The OD 145b of the slot 145 is defined to be greater than the ID 145a of the slot 145 but less than the outer ring diameter (ORD) of the confinement ring 140, wherein the ORD is defined by the outer radius 150 of the confinement ring 140. In other words, the slots 145 extend for a length '1' (i.e., 1 = OD - ID) that is less than the width 'w' (i.e., w = ORD-IRD) of the lower horizontal section 143. Each slot 145 is defined using parallel slot geometry, wherein the inner slot radius (ISR) 145c at the inner diameter (ID) 145a of the slot 145 is equal to the outer slot radius (OSR) 145d at the outer diameter (OD) 145b of the slot 145. Each slot 145 with the parallel slot geometry is defined to extend between the top surface 143a and the bottom surface 143b of the lower horizontal section 143.

FIG. 4B illustrates an alternate implementation of the slot 145' defined along the surface of the lower horizontal section 143 of a confinement ring 140". In this implementation, the slots 145' are defined using tapered slot geometry instead of the parallel slot geometry used to define the slots 145 in FIG. 4A. As with FIG. 4A, each slot 145' extends from an inner diameter (ID) 145a to an outer diameter (OD) 145b. The ID 145a is greater than the IRD of the lower horizontal section 143, wherein the IRD is defined by the lower inner radius 152. The OD 145b is greater than the IRD but is less than the ORD of the confinement ring 140", wherein the ORD is defined by the outer radius 150. In this implementation, each of the plurality of slots 145' is defined, using tapered slot geometry, to include a slot taper. The slot taper is formed by defining a narrow inner slot radius (ISR) 145c' at the ID 145a of the slot 145' and a broader outer slot radius (OSR) 145d' at the OD 145b of the slot 145'. The variation in the ISR 145c' and OSR 145d' results in each slot 145' being narrower at the inner diameter ID 145a and wider at the outer diameter OD 145b. To compensate for narrow ISR at the inner diameter ID 145a, in one implementation, the length '1' of the slot 145' may be increased so as to provide sufficient area for the by-products and neutral gas species to escape the plasma region 108. In alternate implementation, a number of the slots 145' may be increased to compensate for the narrow ISR 145c' at the ID 145a, wherein the number by which the slots 145' is increased corresponds to the wear of the slots 145'.

The ISR 145c' and the OSR 145d' of each slot 145' are sized to be an inverse of a wear rate at the corresponding inner and outer diameters (ID 145a, OD 145b) of the slot 145'. The wear along the length of the slot 145' is uneven due to amount of exposure the different portions along the length of the slot 145' have to the plasma with the area of the slot 145' at the inner diameter getting more wear than the area of the slot 145' at the outer diameter. Making the slots narrower at the ID 145a will increase the lifetime of the confinement ring by offsetting the onset of reaching the critical width when plasma escapes through the slot. At the same time, making the OD 145b of the slot larger ensures that there is no loss in gas conductance due to the ID 145a being narrower. The tapered slot geometry allows the wear of the slot 145' at the ID 145a to reach the critical dimension at about the same time as the wear of the slot 145' at the OD 145b. Even with the taper slot geometry, the size of the ISR and the OSR are defined to enable removal of the by-products and the neutral gas species from the plasma region 108. The taper geometry used to define the slot extends the usage life of the confinement ring 140'.

The slots 145 and 145' illustrated in FIGs. 4A and 4B are not to scale, and have been exaggerated to illustrate the slot profile used to define the slots along the length of the lower horizontal section 143 of the confinement ring 140, 140". In some of the implementations where the confinement ring 140 includes an angled top surface 143a and an angled bottom surface 143b along the length of the lower horizontal section 143, the angle of the bottom surface is defined to be equal to the angle on the top surface in order to keep the bottom surface parallel to the top surface. This design assists in improving the mechanical strength of the confinement ring 140, thereby improving the usage life. Further improvement in the usage life may be envisioned by using tapered slot profile for defining the slots along the lower horizontal section 143 of the confinement ring 140. The tapered slot profiles used to define the slots 145 together with the sloped lower horizontal section 143 result in maintaining optimal plasma density in the plasma region 108 in order to provide optimal etch rate across the surface of the substrate while ensuring the wear of the slots along the length of the slots reach critical dimensions at about the same time.

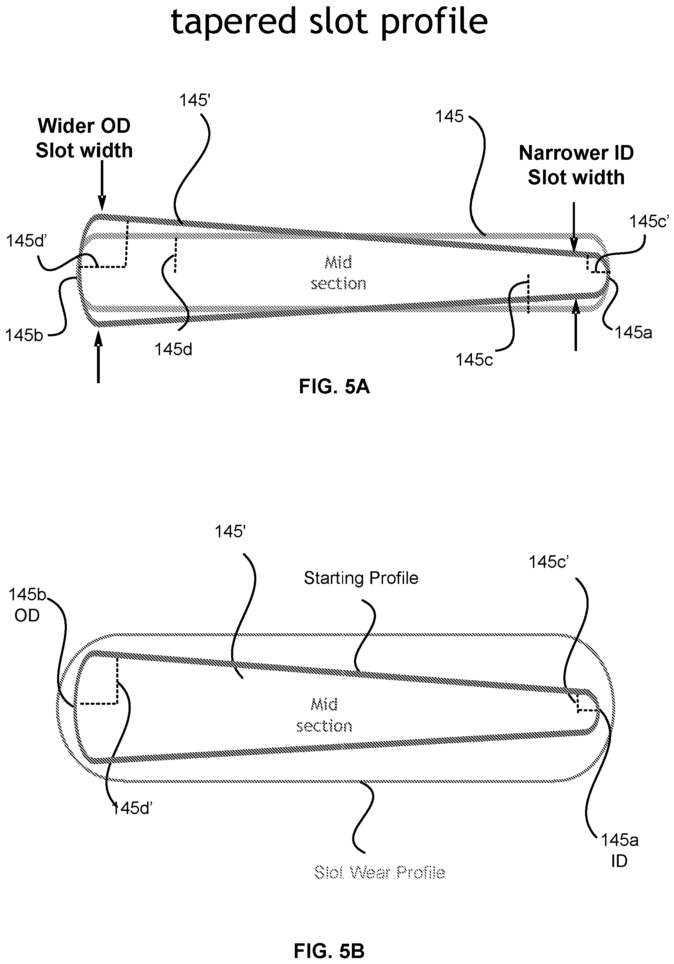

FIG. 5A illustrates an example of a tapered slot profile used to define the slots 145' along the lower horizontal section 143 of the confinement ring 140 used in the plasma processing chamber, in one implementation. FIG. 5A also shows a variation in the slot profile of the slot 145' defined using the tapered slot profile in relation to the slot 145 defined using the parallel slot profile. The slot 145' with the tapered slot profile is shown in red line while the slot 145 with parallel slot profile is shown in grey line. As previously stated, the slots 145' are defined to extend between an inner diameter (ID) 145a and an outer diameter (OD) 145b along the horizontal surface of the lower horizontal section 143, wherein the ID 145a of the slots 145' is greater than inner ring diameter (IRD) defined by the lower inner radius 152 of the lower horizontal section 143 and the OD 145b of the slots 145' is greater than the ID 145a but less than outer ring diameter (ORD) of the confinement ring defined by the outer radius 150. The slot 145' (shown in red line in FIG. 5A) includes a wider or broader slot width at the outer diameter (OD) defined by the outer slot radius (OSR) 145d' and a narrower slot width at the inner diameter (ID) defined by the inner slot radius (ISR) 145c'(i.e., ISR 145c' < OSR 145d'). As the slot wears differently along the slot length, the tapered geometry of the slot 145' provides more area at the inner diameter for the slot wear than at the outer diameter so that the tapered slot 145' as a whole can reach the critical dimension at about the same time, when the confinement ring 140' needs to be replaced. This is different from the slot 145 (shown in grey line in FIG. 5A) that is defined using parallel slot profile. The slot 145 with the parallel slot profile is defined with a uniform slot width along a length of the slot 145 - i.e., an inner slot width at the ID 145a of the slot 145 defined by the ISR 145c is equal to an outer slot width at the OD 145b defined by the OSR 145d. The parallel slot profile may cause an uneven wear along the length of the slot 145 requiring the confinement ring 140 as a whole to be replaced.

Thus, in order to prevent the premature replacement of the confinement ring 140 and to prolong the usage life of the confinement ring while ensuring the mechanical strength of the confinement ring is not compromised throughout its useful life, the confinement ring 140 may be designed to include the lower horizontal section 143 with the slope defined along both the top surface 143a and the bottom surface 143b of the lower horizontal section 143 and slots 145' with tapered slot profile. Adding the slope to the bottom surface 143b of the lower horizontal section 143, keeps the bottom surface parallel to the angled top surface, especially when the slope defined on the bottom surface 143b is equal to the slope defined on the top surface 143a, improving the mechanical strength of the confinement ring. Variations in the design of the confinement ring 140, such as defining slope along the top surface 143a of the lower horizontal section 143 and slots 145 with the parallel slot profile, or defining slope along the top surface 143a of the lower horizontal section 143 and slots 145' with tapered slot profile may also be envisioned to improve the plasma density across the length of the substrate surface.

FIG. 5B illustrates an example wear profile of slots 145' defined with tapered slot profile, in one implementation. The starting profile of the slot 145' is shown in the center in thick red line, wherein the ISR 145c' at the ID 145a is less than the OSR 145d' at the OD 145b. As the confinement ring 145' gets exposed to the plasma from the plasma region 108, during process operations, the areas along the length of the slot 145' shows uneven wear, with the area near the inner diameter (ID) 145a showing more wear than the area around the outer diameter (OD) 145b. As the rate of wear at the narrow end near the inner diameter of the slot 145' is high and the rate of wear at the broader end near the outer diameter of the slot 145' is low, the area near the broader end reaches the critical dimension limit slower than the area near the narrow end and the broader end of the slot 145' can therefore withstand the same amount of process operations as the narrow end before the broader end of the slot 145' reaches the critical dimension limit thereby extending the usage life of the confinement ring 140'. FIG. 5B shows the end-of-life profile of the tapered slot 145' as thin rounded rectangle surrounding the tapered slot 145' wherein the wear in the areas along the length of the tapered slot reaches the critical dimension at about the same time when the confinement ring needs to be replaced to avoid occurrence of plasma un-confinement event. For more information related to use of tapered slot profile for defining the slots 145' along the lower horizontal section 143 of a confinement ring, reference can be made to co-owned and co-pending International Patent Application No. PCT/US20/053894, filed on October 30, 2020, and entitled "Wear Compensating Confinement Ring".

In some implementation, the slot taper defined by the wider slot dimension at the outer diameter OD 145b and the narrow slot dimension at the inner diameter ID 145a, is sized to be an inverse of the wear rate. By sizing the slot taper as a function of the wear rate, the high wear rate at the inner diameter ID 145a is compensated for by the low wear rate at the outer diameter OD 145b, thereby resulting in an approximate straight slot profile at end of life. The slot width along the entire slot length reaches the confinement limit (i.e., critical dimension) at about the same time. The tapered geometry makes use of the area at the outer diameter more effectively. To compensate for the open areas in the lower horizontal section due to decrease in the dimension of the slot at the inner diameter, additional slots may be defined. The number of additional slots may be defined by taking into consideration the amount of wear space required at the narrow end and the broad end for each slot to reach the critical dimension. The tapered slot geometry extends the amount of wear the slot can tolerate before reaching the unconfinement limit, resulting in longer usage life and improved cost of consumables.

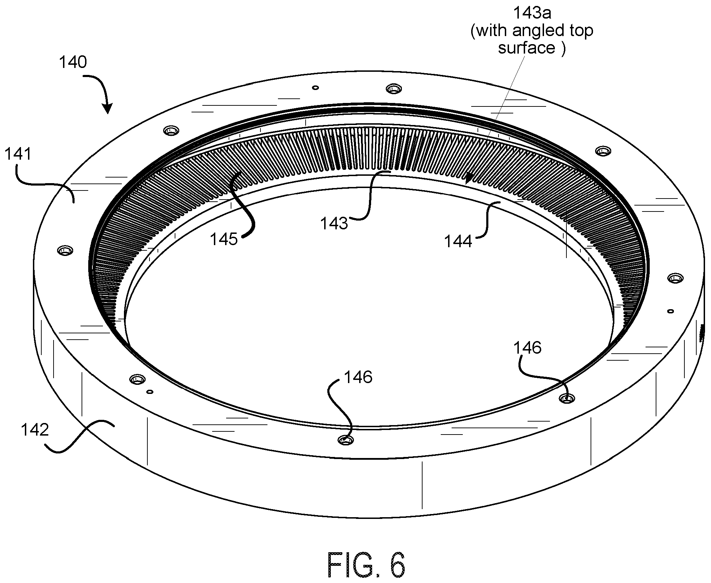

FIG. 6 illustrates a top perspective view of the confinement ring 140 used in the plasma processing chamber 100 to confine the plasma in the plasma region 108. The confinement ring 140 is a C-shaped structure that is configured to be disposed along a periphery of the plasma region 108 to confine the plasma in the plasma region 108 that extends over a substrate 110 received on substrate support surface defined in the lower electrode, edge ring 112 and one or more dielectric rings 120. The confinement ring 140 is a replaceable consumable part. A top surface of the confinement ring includes a plurality of fastener holes 146 disposed uniformly in a circular orientation, wherein the fastener holes 146 are configured to align with and receive fastener means defined along a bottom surface of the outer electrode 102b of the upper electrode 102. The confinement ring 140 illustrated in FIG. 4 shows an angled slope defined along a top surface 143a in the lower horizontal section 143 of the confinement ring 140. Additional slope may be defined along a bottom surface 143b of the lower horizontal section 143 to improve the plasma density along the length of the substrate and the mechanical strength of the confinement ring so that the confinement ring 140 can withstand additional process operations. The lower horizontal section 143 may also include slots with either parallel slot profile or tapered slot profile. The tapered slot profile provides additional benefit over the parallel slot profile in that the tapered slot profile provides additional area for wear near the inner diameter than the outer diameter, leading to improved usage life of the confinement ring.

The advantages of the confinement ring described in the various implementations include improving plasma uniformity without adversely affecting other hardware components (e.g., chamber spacer plate, mating hardware, etc.) or adversely impacting the mechanical strength or lifetime usage of the confinement ring. The plasma uniformity is modulated by doing modifications to the shape of the confinement ring without affecting the strength or the original lifetime expectancy of the confinement ring. This results in improved cost of the consumable confinement ring as the confinement ring can withstand more process operations before reaching the critical dimension limits along the lower horizontal section and along the length of the slot. Other advantages will be envisioned by one skilled in the art upon reviewing the various implementations described herein.

## Claims

1. A confinement ring (140) for use in a plasma processing chamber, including,
an upper horizontal section (141) extending between an upper inner radius (151) and an outer radius (150) of the confinement ring;
a lower horizontal section (143) extending between a lower inner radius (152) and the outer radius (150) of the confinement ring, a top surface (143a) of the lower horizontal section (143) provides for an angle down toward the lower inner radius (152), the lower horizontal section (143) having an extension section (144) that extends to the lower inner radius (152); and
a vertical section (142) disposed between the outer radius (150) and an inside radius (153) of the confinement ring (140), the vertical section (142) connects the upper horizontal section (141) to the lower horizontal section (143) of the confinement ring (140).

2. The confinement ring of claim 1, wherein a bottom surface of the lower horizontal section is flat, such that a first thickness of the lower horizontal section near the inside radius is greater than a second thickness of the lower horizontal section at the lower inner radius.

3. The confinement ring of claim 2, wherein the first thickness is greater than the second thickness from about 10% to about 40%.

4. The confinement ring of claim 1, wherein the angle defines a slope along the top surface of the lower horizontal section, the slope is between about 0.20° and about 1° measured from a horizontal x-axis.

5. The confinement ring of claim 1, wherein a bottom surface of the lower horizontal section provides for a second angle down toward the lower inner radius, the second angle defines a second slope along the bottom surface of the lower horizontal section, the second angle of the second slope along the bottom surface being equal to the angle of the slope along the top surface of the lower horizontal section, and
wherein a first thickness of the lower horizontal section defined near the inside radius is equal to a second thickness of the lower horizontal section defined at the lower inner radius.

6. The confinement ring of claim 1, wherein a first height defined between a bottom surface of the upper horizontal section and the top surface of the lower horizontal section near the inside radius is less than a second height defined between the bottom surface of the upper horizontal section and the top surface of the lower horizontal section at the lower inner radius of the confinement ring.

7. The confinement ring of claim 1, wherein the lower horizontal section, the vertical section and the upper horizontal section are integrally connected to define a C-shaped structure.

8. The confinement ring of claim 1, the lower horizontal section further includes a plurality of slots, wherein each slot extends radially from an inner diameter to an outer diameter along the lower horizontal section, an inner slot radius of each slot at the inner diameter is equal to an outer slot radius of each slot at the outer diameter, and wherein the inner diameter of the slot is greater than an inner ring diameter of the confinement ring defined by the lower inner radius and the outer diameter of the slot is less than an outer ring diameter of the confinement ring defined by the outer radius.

9. The confinement ring of claim 1, the lower horizontal section further includes a plurality of slots, wherein each slot extends radially from an inner diameter to an outer diameter along the lower horizontal section, an inner slot radius of each slot at the inner diameter is less than an outer slot radius of each slot at the outer diameter.

10. The confinement ring of claim 9, wherein a difference in the inner slot radius and the outer slot radius of each slot defines a slot taper, each slot tapers down from the outer diameter to the inner diameter, wherein the inner slot radius and the outer slot radius influencing the slot taper are defined to be an inverse of a wear rate at the corresponding inner diameter and the outer diameter of the slot, and
wherein a ratio of the inner slot radius to the outer slot radius is between about 1 : 1.1 and 1 : 1.5.

11. The confinement ring of claim 1, wherein the upper inner radius is greater than the lower inner radius, wherein the extension section extends vertically downward at the lower inner radius, and wherein the extension section includes an angled top section and a vertical bottom section, the angled top section provides a third angle down at a downward incline point defined on the top surface at the lower inner radius of the lower horizontal section and the vertical bottom section is defined to extend downward from a bottom portion of the angled top section.

12. The confinement ring of claim 1, wherein a top surface of the upper horizontal section includes a plurality of holes, each hole of the plurality of holes is configured to receive a portion of a fastener means defined on a bottom surface of the upper electrode for coupling the confinement ring to the upper electrode of the plasma processing chamber, and wherein the extension section of the lower horizontal section is configured to rest on a radio frequency gasket defined on a top surface of a lower electrode of the plasma processing chamber.

13. A plasma processing chamber (100) for confining plasma within, the plasma processing chamber includes a lower electrode (104) for supporting a substrate and an upper electrode (102) disposed over the lower electrode (104), the plasma processing chamber comprising,
a confinement ring (140) disposed between the lower electrode (104) and the upper electrode (102), the confinement ring (140) according to any one of claims 1-12.

14. The plasma processing chamber of claim 13, wherein the confinement ring defined by the lower horizontal section, the upper horizontal section and the vertical section defines a contiguous C-shaped structure for confining plasma generated in the plasma processing chamber to a plasma region (108), the confinement ring is made from one of silicon, or polysilicon, or silicon carbide, or boron carbide, or ceramic, or aluminum.

15. The plasma processing chamber of claim 13, wherein the upper electrode is electrically grounded and the lower electrode is connected to a radio frequency power source (106) through a corresponding match network (107).

## Patentansprüche

1. Einschlussring (140) zur Verwendung in einer Plasmabehandlungskammer, der Folgendes umfasst:
einen oberen horizontalen Abschnitt (141), der sich zwischen einem oberen Innenradius (151) und einem Außenradius (150) des Einschlussrings erstreckt;
einen unteren horizontalen Abschnitt (143), der sich zwischen einem unteren Innenradius (152) und dem Außenradius (150) des Einschlussrings erstreckt, wobei eine Oberseite (143a) des unteren horizontalen Abschnitts (143) einen Winkel nach unten in Richtung zum unteren Innenradius (152) bereitstellt, wobei der untere horizontale Abschnitt (143) einen Erstreckungsabschnitt (144) aufweist, der sich zum unteren Innenradius (152) erstreckt; und
einen vertikalen Abschnitt (142), der zwischen dem Außenradius (150) und einem Innenseitenradius (153) des Einschlussrings (140) erstreckt, wobei der vertikale Abschnitt (142) den oberen horizontalen Abschnitt (141) mit dem unteren horizontalen Abschnitt (143) des Einschlussrings (140) verbindet.

2. Einschlussring nach Anspruch 1, wobei die Unterseite des unteren horizontalen Abschnitts flach ist, sodass eine erste Dicke des unteren horizontalen Abschnitts nahe des Innenseitenradius größer ist als eine zweite Dicke des unteren horizontalen Abschnitts am unteren Innenradius.

3. Einschlussring nach Anspruch 2, wobei die erste Dicke größer um etwa 10 % bis etwa 40 % größer ist als die zweite Dicke.

4. Einschlussring nach Anspruch 1, wobei der Winkel eine Neigung entlang der Oberseite des unteren horizontalen Abschnitts definiert, wobei die Neigung, von der horizontalen x-Achse gemessen, zwischen etwa 0,20° und etwa 1° beträgt.

5. Einschlussring nach Anspruch 1, wobei die Unterseite des unteren horizontalen Abschnitts einen zweiten Winkel nach unten in Richtung zum unteren Innenradius bereitstellt, wobei der zweite Winkel eine zweite Neigung entlang der Unterseite des unteren horizontalen Abschnitts definiert, wobei der zweite Winkel der zweiten Neigung entlang der Unterseite gleich dem Winkel der Neigung entlang der Oberseite des unteren horizontalen Abschnitts ist und wobei
eine erste Dicke des unteren horizontalen Abschnitts, die nahe des Innenseitenradius definiert ist, gleich einer zweiten Dicke des unteren horizontalen Abschnitts ist, der am unteren Innenradius definiert ist.

6. Einschlussring nach Anspruch 1, wobei eine erste Höhe, die zwischen der Unterseite des oberen horizontalen Abschnitts und der Oberseite des unteren horizontalen Abschnitts nahe dem Innenseitenradius definiert ist, geringer ist als eine zweite Höhe, die zwischen der Unterseite des oberen horizontalen Abschnitts und der Oberseite des unteren horizontalen Abschnitts am unteren Innenradius des Einschlussrings definiert ist.

7. Einschlussring nach Anspruch 1, wobei der untere horizontale Abschnitt, der vertikale Abschnitt und der obere horizontale Abschnitt einstückig verbunden sind, um eine C-förmige Struktur zu definieren.

8. Einschlussring nach Anspruch 1, wobei der untere horizontale Abschnitt weiters eine Vielzahl von Schlitzen umfasst, wobei sich jeder Schlitz radial von einem Innendurchmesser zu einem Außendurchmesser entlang des unteren horizontalen Abschnitts erstreckt, wobei ein innerer Schlitzradius von jedem Schlitz am Innendurchmesser gleich einem äußeren Schlitzradius jedes Schlitzes am Außendurchmesser ist und wobei der Innendurchmesser des Schlitzes größer ist als ein Innenringdurchmesser des Einschlussrings, der durch den unteren Innenradius definiert ist, und der Außendurchmesser des Schlitzes kleiner ist als ein Außenringdurchmesser des Einschlussrings, der durch den Außenradius definiert ist.

9. Einschlussring nach Anspruch 1, wobei der untere horizontale Abschnitt weiters eine Vielzahl von Schlitzen umfasst, wobei sich jeder Schlitz radial von einem Innendurchmesser zu einem Außendurchmesser entlang des unteren horizontalen Abschnitts erstreckt, wobei ein innerer Schlitzradius jedes Schlitzes am Innendurchmesser kleiner ist als ein äußerer Schlitzradius jedes Schlitzes am Außendurchmesser.

10. Einschlussring nach Anspruch 9, wobei eine Differenz zwischen dem inneren Schlitzradius und dem äußeren Schlitzradius jedes Schlitzes eine Schlitzverjüngung definiert, wobei sich jeder Schlitz vom Außendurchmesser zum Innendurchmesser verjüngt, wobei der innere Schlitzradius und der äußere Schlitzradius, die sich auf die Schlitzverjüngung auswirken, als Kehrwert einer Verschleißrate am entsprechenden Innendurchmesser und Außendurchmesser des Schlitzes definiert sind, und
wobei das Verhältnis zwischen dem inneren Schlitzradius und dem äußeren Schlitzradius zwischen etwa 1:1,1 und 1:1,5 liegt.

11. Einschlussring nach Anspruch 1, wobei der obere Innenradius größer ist als der untere Innenradius, wobei sich der Erstreckungsabschnitt am unteren Innenradius vertikal nach unten erstreckt und wobei der Erstreckungsabschnitt einen winkeligen oberen Abschnitt und einen vertikalen unteren Abschnitt umfasst, wobei der winkelige obere Abschnitt einen dritten Winkel nach unten an einem nach unten geneigten Punkt bereitstellt, der auf der Oberseite am unteren Innenradius des unteren horizontalen Abschnitts definiert ist, und der vertikale untere Abschnitt so definiert ist, dass er sich von einem unteren Abschnitt des gewinkelten oberen Abschnitts nach unten erstreckt.

12. Einschlussring nach Anspruch 1, wobei eine Oberseite des oberen horizontalen Abschnitts eine Vielzahl von Löchern umfasst, wobei jedes Loch der Vielzahl von Löcher ausgelegt ist, einen Abschnitt eines Befestigungsmittels aufzunehmen, das auf einer Unterseite der oberen Elektrode definiert ist, um den Einschlussring mit der oberen Elektrode der Plasmabehandlungskammer zu koppeln, und wobei der Erstreckungsabschnitt des unteren horizontalen Abschnitts ausgelegt ist, auf einer Hochfrequenzdichtung aufzuliegen, die auf einer Oberseite einer unteren Elektrode der Plasmabehandlungskammer definiert ist.

13. Plasmabehandlungskammer (100) zum Einschließen von Plasma darin, wobei die Plasmabehandlungskammer eine untere Elektrode (104) zum Tragen eines Substrats und eine obere Elektrode (102), die über der unteren Elektrode (104) angeordnet ist, umfasst, wobei die Plasmabehandlungskammer
einen Einschlussring (140) umfasst, der zwischen der unteren Elektrode (104) und der oberen Elektrode (102) angeordnet ist, wobei der Einschlussring (140) nach einem der Ansprüche 1-12 ist.

14. Plasmabehandlungskammer nach Anspruch 13, wobei der Einschlussring, der durch den unteren horizontalen Abschnitt, den oberen horizontalen Abschnitt und den vertikalen Abschnitt definiert ist, eine zusammenhängende C-förmige Struktur zum Einschließen von Plasma, das in der Plasmabehandlungskammer erzeugt wird, in einem Plasmabereich (108) definiert, wobei der Einschlussring aus Silikon, Polysilikon, Silikoncarbid, Borcarbid, Keramik oder Aluminium besteht.

15. Plasmabehandlungskammer nach Anspruch 13, wobei die obere Elektrode elektrisch geerdet ist und die untere Elektrode über ein entsprechendes Anpassungs-Netzwerk (107) mit einer Hochleistungsfrequenzquelle (106) verbunden ist.

## Revendications

1. Anneau de confinement (140) destiné à être utilisé dans une chambre de traitement au plasma, comprenant une section horizontale supérieure (141) s'étendant entre un rayon interne supérieur (151) et un rayon externe (150) de l'anneau de confinement ;
une section horizontale inférieure (143) s'étendant entre un rayon interne inférieur (152) et le rayon externe (150) de l'anneau de confinement, une surface supérieure (143a) de la section horizontale inférieure (143) fournit un angle vers le bas vers le rayon interne inférieur (152), la section horizontale inférieure (143) ayant une section d'extension (144) qui s'étend vers le rayon interne inférieur (152) ; et
une section verticale (142) disposée entre le rayon externe (150) et un rayon interne (153) de l'anneau de confinement (140), la section verticale (142) relie la section horizontale supérieure (141) à la section horizontale inférieure (143) de l'anneau de confinement (140).

2. Anneau de confinement selon la revendication 1, dans lequel une surface inférieure de la section horizontale inférieure est plate, de sorte qu'une première épaisseur de la section horizontale inférieure à proximité du rayon interne est supérieure à une seconde épaisseur de la section horizontale inférieure au niveau du rayon interne inférieur.

3. Anneau de confinement selon la revendication 2, dans lequel la première épaisseur est supérieure à la seconde épaisseur d'environ 10 % à environ 40 %.

4. Anneau de confinement selon la revendication 1, dans lequel l'angle définit une pente le long de la surface supérieure de la section horizontale inférieure, la pente est comprise entre environ 0,20° et environ 1° mesurée à partir d'un axe x horizontal.

5. Anneau de confinement selon la revendication 1, dans lequel une surface inférieure de la section horizontale inférieure fournit un deuxième angle vers le bas en direction du rayon interne inférieur, le deuxième angle définit une seconde pente le long de la surface inférieure de la section horizontale inférieure, le deuxième angle de la seconde pente le long de la surface inférieure étant égal à l'angle de la pente le long de la surface supérieure de la section horizontale inférieure, et
dans lequel une première épaisseur de la section horizontale inférieure définie à proximité du rayon interne est égale à une seconde épaisseur de la section horizontale inférieure définie au niveau du rayon interne inférieur.

6. Anneau de confinement selon la revendication 1, dans lequel une première hauteur définie entre une surface inférieure de la section horizontale supérieure et la surface supérieure de la section horizontale inférieure près du rayon interne est inférieure à une seconde hauteur définie entre la surface inférieure de la section horizontale supérieure et la surface supérieure de la section horizontale inférieure au niveau du rayon interne inférieur de l'anneau de confinement.

7. Anneau de confinement selon la revendication 1, dans lequel la section horizontale inférieure, la section verticale et la section horizontale supérieure sont connectées d'un seul tenant pour définir une structure en forme de C.

8. Anneau de confinement selon la revendication 1, la section horizontale inférieure comprenant en outre une pluralité de fentes, dans lequel chaque fente s'étend radialement d'un diamètre interne à un diamètre externe le long de la section horizontale inférieure, un rayon de fente interne de chaque fente au niveau du diamètre interne est égal à un rayon de fente externe de chaque fente au niveau du diamètre externe, et dans lequel le diamètre interne de la fente est supérieur à un diamètre d'anneau interne de l'anneau de confinement défini par le rayon interne inférieur, et le diamètre externe de la fente est inférieur à un diamètre d'anneau externe de l'anneau de confinement défini par le rayon externe.

9. Anneau de confinement selon la revendication 1, la section horizontale inférieure comprenant en outre une pluralité de fentes, dans laquelle chaque fente s'étend radialement d'un diamètre interne à un diamètre externe le long de la section horizontale inférieure, un rayon de fente interne de chaque fente au niveau du diamètre interne est inférieur à un rayon de fente externe de chaque fente au niveau du diamètre externe.

10. Anneau de confinement selon la revendication 9, dans lequel une différence dans le rayon de fente interne et le rayon de fente externe de chaque fente définit une conicité de fente, chaque fente étant effilée du diamètre externe au diamètre interne, dans lequel le rayon de fente interne et le rayon de fente externe influençant la conicité de fente sont définis comme étant un inverse d'un taux d'usure au niveau du diamètre interne correspondant et du diamètre externe de la fente, et
dans lequel un rapport du rayon de fente interne au rayon de fente externe est compris entre environ 1:1,1 et 1:1,5.

11. Anneau de confinement selon la revendication 1, dans lequel le rayon interne supérieur est supérieur au rayon interne inférieur, dans lequel la section d'extension s'étend verticalement vers le bas au niveau du rayon interne inférieur, et dans lequel la section d'extension comprend une section supérieure angulaire et une section inférieure verticale, la section supérieure angulaire fournit un troisième angle vers le bas au niveau d'un point d'inclinaison vers le bas défini sur la surface supérieure au niveau du rayon interne inférieur de la section horizontale inférieure, et la section inférieure verticale est définie pour s'étendre vers le bas à partir d'une partie inférieure de la section supérieure angulaire.

12. Anneau de confinement selon la revendication 1, dans lequel une surface supérieure de la section horizontale supérieure inclut une pluralité de trous, chaque trou de la pluralité de trous est configuré pour recevoir une partie d'un moyen de fixation défini sur une surface inférieure de l'électrode supérieure pour coupler l'anneau de confinement à l'électrode supérieure de la chambre de traitement au plasma, et dans lequel la section d'extension de la section horizontale inférieure est configurée pour reposer sur un joint radiofréquence défini sur une surface supérieure d'une électrode inférieure de la chambre de traitement au plasma.

13. Chambre de traitement au plasma (100) pour confiner du plasma en son sein, la chambre de traitement au plasma comprend une électrode inférieure (104) pour supporter un substrat et une électrode supérieure (102) disposée au-dessus de l'électrode inférieure (104), la chambre de traitement au plasma comprenant :
un anneau de confinement (140) disposé entre l'électrode inférieure (104) et l'électrode supérieure (102), l'anneau de confinement (140) selon l'une quelconque des revendications 1 à 12.

14. Chambre de traitement au plasma selon la revendication 13, dans laquelle l'anneau de confinement défini par la section horizontale inférieure, la section horizontale supérieure et la section verticale définit une structure contiguë en forme de C pour confiner du plasma généré dans la chambre de traitement au plasma vers une région de plasma (108), l'anneau de confinement est fait de silicium, ou de polysilicium, ou de carbure de silicium, ou de carbure de bore, ou de céramique, ou d'aluminium.

15. Chambre de traitement au plasma selon la revendication 13,
dans lequel l'électrode supérieure est mise à la terre électriquement et l'électrode inférieure est connectée à une source d'alimentation radiofréquence (106) par l'intermédiaire d'un réseau d'adaptation correspondant (107).
